# FASCICULE DE BREVET EUROPEEN

(11) **EP 1 073 201 B1**
(45) Date de publication et mention de la délivrance du brevet: **02.05.2003**
(21) Numéro de dépôt: 00410084.8
(22) Date de dépôt: 28.07.2000
(51) Int. Cl.: H03K 3/03

(54) **Oscillateur à faible consommation**
Verbrauchsarmer Oszillator
Low consumption oscillator

(30) Priorité: 29.07.1999 FR 9910043
(43) Date de publication de la demande: 31.01.2001
(73) Titulaire: STMicroelectronics S.A., 92120 Montrouge (FR)
(72) Inventeur: Ferrant, Richard, 38920 Crolles (FR)
(74) Mandataire: de Beaumont, Michel

(56) Documents cités:
- US-A- 5 150 081
- US-A- 5 872 033
- "CIRCUIT OSCILLATEUR A TRANSISTORS MOS" TOUTE L'ELECTRONIQUE., no. 383, décembre 1973 (1973-12), page 107 XP002135484 SOCIETE DES EDITIONS RADIO. PARIS., FR

## Description

La présente invention concerne un oscillateur à quartz construit autour d'un inverseur en technologie CMOS, et plus particulièrement un oscillateur à faible consommation.

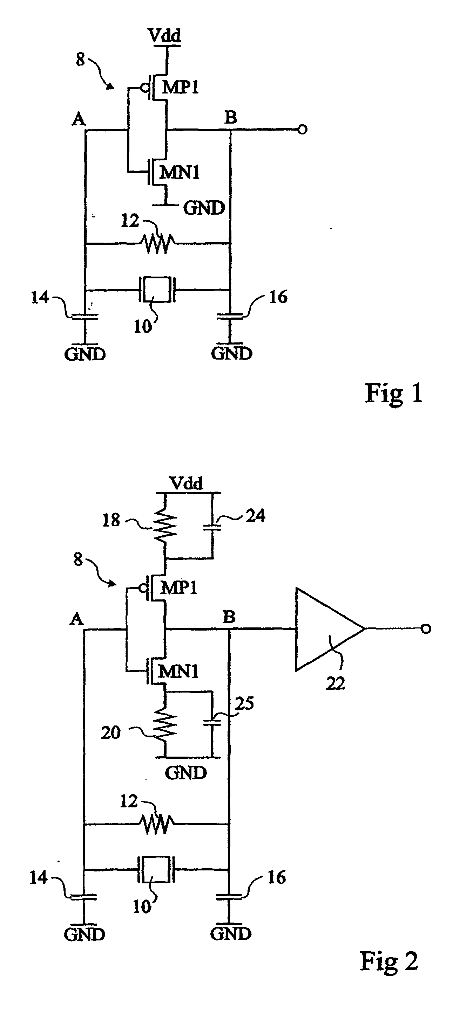

La figure 1 représente un tel oscillateur. Il comprend un inverseur 8 constitué d'un transistor MOS MP1 à canal P et d'un transistor MOS MN1 à canal N connectés en série entre un potentiel d'alimentation haut Vdd et un potentiel d'alimentation bas GND. Les grilles des transistors MP1 et MN1 sont connectées l'une à l'autre et constituent l'entrée A de l'inverseur. La sortie B de l'inverseur, qui est également la sortie de l'oscillateur, est prélevée sur les drains des transistors MP1 et MN1. Un cristal de quartz 10 est connecté en parallèle avec une résistance 12 entre l'entrée et la sortie de l'inverseur 8. Par ailleurs, deux condensateurs 14 et 16 relient respectivement l'entrée et la sortie de l'inverseur 8 au potentiel d'alimentation bas GND.

Un tel oscillateur consomme une puissance proportionnelle à la fréquence d'oscillation, cette consommation étant due essentiellement à la conduction simultanée des transistors MP1 et MN1 lors des transitions du signal de sortie.

La figure 2 représente une solution couramment employée pour réduire la consommation d'un oscillateur du type de la figure 1. Les transistors MP1 et MN1, au lieu d'être directement connectés aux potentiels Vdd et GND, sont connectés à ces potentiels par l'intermédiaire de résistances respectives 18 et 20.

Avec cette configuration, on diminue les courants de commutation de l'inverseur 8 proportionnellement à la valeur des résistances 18 et 20. Toutefois, l'amplitude du signal de sortie diminue d'autant plus que les résistances 18 et 20 ont des valeurs élevées. Cette diminution d'amplitude ne nuit pas au fonctionnement de l'oscillateur, mais il faut néanmoins prévoir un amplificateur 22 pour ramener les niveaux crête du signal de l'oscillateur à des niveaux proches des potentiels d'alimentation pour générer un signal logique exploitable.

Accessoirement, on connecte des condensateurs 24 et 25 en parallèle avec les résistances 18 et 20, ce qui offre un lissage de la tension aux bornes des transistors MP1 et MN1 et une diminution de l'impédance dynamique de sortie de l'inverseur.

Les résistances 18 et 20 peuvent être choisies avec des valeurs particulièrement élevées sans nuire au fonctionnement de l'oscillateur. Un problème réside toutefois en la réalisation de résistances de valeur élevée dans un circuit intégré. Dans un circuit intégré, une résistance est constituée d'une piste de silicium polycristallin dont la longueur est proportionnelle à la valeur de la résistance. Pour réaliser des résistances de valeur convenable pour un oscillateur à faible consommation du type de la figure 2, les pistes de silicium polycristallin occuperaient une surface non négligeable.

Un objet de la présente invention est de prévoir un oscillateur à consommation particulièrement faible ne nécessitant pas de résistance occupant une surface importante.

Pour atteindre cet objet, la présente invention prévoit un oscillateur à faible consommation réalisé à partir d'un inverseur relié à un potentiel d'alimentation haut et à un potentiel d'alimentation bas par l'intermédiaire de deux résistances respectives. Les résistances sont constituées de condensateurs ayant des fuites élevées.

Selon un mode de réalisation de la présente invention, la sortie de l'oscillateur est reliée à un amplificateur destiné à fournir des niveaux logiques à partir des niveaux de sortie de l'oscillateur.

Selon un mode de réalisation de la présente invention, l'amplificateur comprend plusieurs étages comportant chacun deux transistors connectés en série entre les potentiels d'alimentation haut et bas, la grille d'un premier des transistors de chaque étage étant reliée à la sortie de l'étage précédent, et les grilles des deuxièmes transistors de deux étages consécutifs étant reliées respectivement à l'entrée et à la sortie dudit inverseur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente un oscillateur à quartz classique ;
la figure 2, précédemment décrite, représente un oscillateur à quartz à faible consommation classique ;
la figure 3 représente un mode de réalisation d'oscillateur à quartz à faible consommation selon la présente invention ; et
la figure 4 représente un exemple d'amplificateur particulièrement avantageux utilisé dans l'oscillateur de la figure 3.

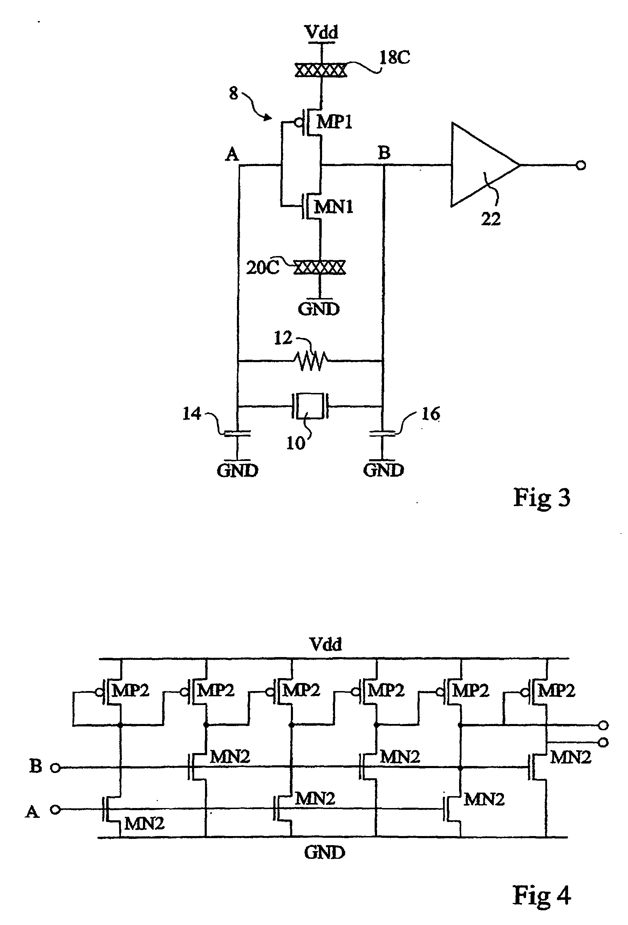

A la figure 3, on retrouve des mêmes éléments qu'aux figures 1 et 2, désignés par des mêmes références. Selon l'invention, les résistances 18 et 20 de l'oscillateur de la figure 2 ont été remplacées par des condensateurs 18C et 20C d'un type particulier. Aucun autre élément n'est prévu pour connecter les transistors MP1 et MN1 aux potentiels d'alimentation Vdd et GND.

Selon l'invention, les condensateurs 18C et 20C sont réalisés de manière à présenter des fuites importantes par rapport à des condensateurs classiques réalisés dans la même technologie. Un condensateur classique présente typiquement une résistance de fuite de l'ordre de 10¹² Ω/µm². Cette résistance est si élevée que l'oscillateur ne peut fonctionner. Par contre, les condensateurs 18C et 20C sont, selon l'invention, dénaturés pour avoir des fuites importantes, par exemple, en dopant leur diélectrique d'impuretés. On obtient ainsi des résistances de fuite de l'ordre de 100 à 1000 MΩ, qui permettent à l'oscillateur de fonctionner. La valeur exacte des résistances importe peu dans la gamme citée ci-dessus (elle est maîtrisable à 20-25 % près). Par contre, il importe, pour avoir un signal symétrique, que les deux condensateurs aient sensiblement la même résistance de fuite. Ceci est facile à garantir dans un même lot de circuits intégrés.

Les résistances que l'on obtient avec cette solution sont nettement plus élevées que celles que l'on peut obtenir avec les procédés classiques (inférieures à 10 MΩ). En outre, la capacité des condensateurs 18C et 20C importe peu. En particulier, les condensateurs peuvent être choisis de la plus petite taille possible, de manière à occuper une surface négligeable.

Les condensateurs 18C et 20C jouent accessoirement le rôle des condensateurs 24 et 25 de la figure 2 et servent donc éventuellement de réservoir de charge.

L'amplitude du signal de sortie de l'oscillateur de la figure 3 est particulièrement faible. Par exemple, dans un oscillateur alimenté sous 2 V et fonctionnant à une fréquence de 50 MHz avec des condensateurs 18C et 20C ayant une résistance de fuite de 100 MΩ, le signal de sortie présente une amplitude de 300 mv crête à crête. Comme pour le circuit de la figure 2, le signal de sortie est fourni à un amplificateur 22 destiné à rendre l'amplitude du signal proche de la tension d'alimentation. L'amplificateur 22 doit pouvoir fonctionner à fréquence élevée tout en ayant une faible consommation.

La figure 4 représente un exemple d'amplificateur satisfaisant à ces conditions. -Cet amplificateur comporte une succession d'étages dont chacun comporte un transistor MOS MP2 à canal P et un transistor MOS MN2 à canal N connectés en série entre le potentiel d'alimentation haut Vdd et le potentiel d'alimentation bas GND. La grille du transistor MP2 d'un étage est connecté à la sortie de l'étage précédent, c'est-à-dire aux drains des transistors MP2 et MN2 de l'étage précédent. Les grilles des transistors MN2 de deux étages successifs sont connectés respectivement à l'entrée A et à la sortie B de l'inverseur 8 de la figure 3. La grille du transistor MP2 du premier étage est connecté à la sortie de ce même étage. La sortie de l'amplificateur est prélevée sur la sortie du dernier étage. Le cas échéant, elle peut être prélevée en différentiel sur les sorties des deux derniers étages.

Le nombre d'étages de l'amplificateur détermine son gain. Le gain est sensiblement égal à 2ⁿ où n est le nombre d'étages.

Le courant de repos de chaque étage peut être choisi particulièrement faible. Il est déterminé par la dimension des transistors MP2 et MN2 et la tension de mode commun sur les bornes d'entrée A et B, cette tension de mode commun étant la moitié de la tension d'alimentation si les résistances de fuite des condensateurs 18C et 20C sont égales.

Bien entendu, la présente invention est susceptible de diverses variantes et modifications qui apparaîtront à l'homme de l'art. Par exemple, l'une des bornes d'entrée de l'amplificateur de la figure 4, au lieu de recevoir le signal de sortie ou d'entrée de l'inverseur 8, peut recevoir une tension constante égale à la tension de mode commun.

## Revendications

1. Oscillateur à faible consommation réalisé à partir d'un inverseur (8) relié à un potentiel d'alimentation haut (Vdd) et à un potentiel d'alimentation bas (GND) par l'intermédiaire de deux résistances respectives, **caractérisé en ce que** les résistances sont constituées de condensateurs (18C, 20C) ayant des fuites élevées.

2. Oscillateur selon la revendication 1, **caractérisé en ce .que** sa sortie est reliée à un amplificateur (22) destiné à fournir des niveaux logiques à partir des niveaux de sortie de l'oscillateur.

3. Oscillateur selon la revendication 2, **caractérisé en ce que** l'amplificateur (22) comprend plusieurs étages comportant chacun deux transistors (MP2, MN2) connectés en série entre les potentiels d'alimentation haut et bas, la grille d'un premier (MP2) des transistors de chaque étage étant reliée à la sortie de l'étage précédent, et les grilles des deuxièmes transistors (MN2) de deux étages consécutifs étant reliées respectivement à l'entrée et à la sortie dudit inverseur (8).

## Patentansprüche

1. Oszillator mit niedrigem Leistungsverbrauch, in Ausbildung auf der Grundlage eines Inverters (8), der über zwei entsprechende Widerstände mit einem hohen (Vdd) und einem niedrigen (GND) Speisepotential verbunden ist, **dadurch gekennzeichnet, dass** die Widerstände von Kondensatoren (18C,20C) mit hohem Leckanteil gebildet werden.

2. Oszillator nach Anspruch 1, **dadurch gekennzeichnet, dass** sein Ausgang mit einem Verstärker (22) verbunden ist, der ddie Aufgabe hat, ausgehend von den Ausgangspegeln des Oszillators Logik-Pegel zu liefern.

3. Oszillator nach Anspruch 2, **dadurch gekennzeichnet, dass** der Verstärker (22) mehrere Stufen umfasst, deren jede jeweils zwei in Reihe zwischen dem hohen und dem niedrigen Speisepotential liegende Transistoren (MP2,MN2) aufweist, dass das Gate eines ersten (MP2) der Transistoren jeder Stufe mit dem Ausgang der vorhergehenden Stufe verbunden ist, und dass die Gate-Anschlüsse der zweiten Transistoren (MN2) von zwei aufeinanderfolgenden Stufen mit dem Eingang beziehungsweise mit dem Ausgang des genannten Inverters (8) verbunden sind.

## Claims

1. A low power consumption oscillator comprising an inverter (8) connected to a high supply potential (Vdd) and to a low supply potential (GND) via two respective resistors, **characterized in that** the resistors are formed of capacitors (18C, 20C) with a strong leakage.

2. The oscillator of claim 1, **characterized in that** its output is connected to an amplifier (22) intended to provide logic levels from the output levels of the oscillator.

3. The oscillator of claim 2, **characterized in that** the amplifier (22) includes several stages, each including two transistors (MP2, MN2) connected in series between the high and low supply potentials, the gate of a first transistor (MP2) of each stage being connected to the output of the preceding stage, and the gates of the second transistors (MN2) of two consecutive stages being respectively connected to the input and to the output of said inverter (8).
